## Europäisches Patentamt
## European Patent Office
## Office européen des brevets

(19)

(11) Numéro de publication: **0 141 695**
**B1**

(12) ## FASCICULE DE BREVET EUROPÉEN

(45) Date de publication du fascicule du brevet:
08.06.88

(51) Int. Cl.⁴: **H 01 L 27/14,** H 04 N 3/15

(21) Numéro de dépôt: **84401747.5**

(22) Date de dépôt: **31.08.84**

(54) Dipositif photosensible à transfert de ligne.

(30) Priorité: **13.09.83 FR 8314543**

(43) Date de publication de la demande:
**15.05.85 Bulletin 85/20**

(45) Mention de la délivrance du brevet:
**08.06.88 Bulletin 88/23**

(84) Etats contractants désignés:
**DE GB NL**

(56) Documents cité:
**EP-A-0 029 351**
**EP-A-0 064 890**
**FR-A-2 360 176**

(73) Titulaire: **THOMSON- CSF, 173, Boulevard Haussmann, F-75379 Paris Cédex 08 (FR)**

(72) Inventeur: **Berger, Jean- Luc THOMSON- CSF, SCPI - 173, bld Haussmann, F-75379 Paris Cedex 08 (FR)**
Inventeur: **Brissot, Louis THOMSON- CSF, SCPI - 173, bld Haussmann, F-75379 Paris Cedex 08 (FR)**
Inventeur: **Cazaux, Yvon THOMSON- CSF, SCPI - 173, bld Haussmann, F-75379 Paris Cedex 08 (FR)**

(74) Mandataire: **Ruellan- Lemonnier, Brigitte, THOMSON- CSF SCPI 19, avenue de Messine, F-75008 Paris (FR)**

LIBER, STOCKHOLM 1988

EP 0 141 695 B1

## Description

La présente invention concerne les dispositifs photosensibles pour l'analyse d'images lumineuses dits "à transfert de ligne".

Comme décrit dans les demandes de brevet EP-A-0 064 890 et EP-A-0 115 225 au nom de THOMSON-CSF, ce type de dispositif comporte principalement :

- une zone photosensible de M lignes de N points photosensibles sur laquelle l'image à lire est projetée et transformée en charges électriques dites charges-signal ;

- un organe d'interface de M points, dit mémoire de ligne, connecté par l'intermédiaire de colonnes conductrices aux points photosensibles des différentes lignes et destiné à recevoir successivement les charges-signal stockées par chaque ligne ;

- un registre à décalage du type CCD (pour "Charge Coupled Devices"), recevant en parallèle le contenu de la mémoire de ligne et délivrant en série le signal électrique d'analyse de l'image.

De préférence, le dispositif photosensible décrit ci-dessus comporte un moyen d'évacuation des charges parasites qui peut être associé à la mémoire de ligne comme décrit dans les demandes de brevet ci-dessus.

Pour accroître la rapidité du transfert des charges-signal ainsi que l'efficacité de transfert, le registre de lecture est, en général, constitué par un registre CCD du type à transfert en volume.

Toutefois, lorsque l'on souhaite, par exemple, injecter des charges à partir du registre de lecture vers la mémoire de ligne, comme décrit dans la demande EP-A-0 115 225 il n'est plus possible d'utiliser un transfert en volume dans le registre de lecture. Dans ce cas pour une même tension appliquée sur les grilles, les potentiels de surface sont à un niveau plus haut que dans le cas d'un transfert en surface et les charges se trouvant dans le registre à décalage ne peuvent pas passer dans la mémoire de ligne.

Dans le document FR-A-2 360 176 il est question d'un dispositif photosensible du type transfert de trame comportant une zone photosensible, une mémoire temporaire et un registre de sortie, dans lequel la mémoire temporaire et le registre de sortie peuvent être constitués par des registres à canal enterré.

La présente invention a en conséquence pour but d'apporter aux dispositifs photosensibles à transfert de ligne, divers perfectionnements permettant d'utiliser un registre de lecture constitué par un registre CCD du type à transfert en volume quel que soit le procédé d'analyse utilisé.

Conformément à la présente invention, la mémoire de ligne du dispositif photosensible à transfert de ligne est réalisée sur au moins une zone de substrat semiconducteur présentant une implantation d'impuretés de type opposé à celui du substrat de manière à réaliser un transfert des charges "en volume", le dopage en impuretés de la zone de réalisation de la mémoire de ligne étant inférieur ou égal à celui de la zone de réalisation du registre à décalage.

Dans le cas où le dopage en impuretés de la zone-mémoire de ligne est égal à celui de la zone du registre à décalage, on obtient une communication bilatérale entre la mémoire de ligne et le registre à décalage, avec tous les avantages d'un transfert en volume.

En fait, si la présente invention semble plus particulièrement intéressante pour réaliser un transfert bilatéral des charges dans le cas des dispositifs photosensibles fonctionnant avec double charge d'entraînement, elle peut aussi être utilisée dans les autres dispsitifs photosensibles à transfert de ligne, car le fait d'utiliser un transfert en volume pour la mémoire de ligne présente un certain nombre d'avantages au niveau de l'efficacité de transfert vertical, du bruit de transfert, etc.

Ainsi pour des tensions appliquées identiques sur les éléments de la mémoire de ligne, le potentiel des colonnes est beaucoup plus élevé. Or, les colonnes sont, pour une grande part, constituées par des diodes de lecture reliées entre elles. Ces diodes sont polarisées en inverse. En conséquence, si leur tension de polarisation est plus importante, elles présentent une capacité plus faible. Ainsi, l'efficacité de transfert vertical qui est inversement proportionnelle à la capacité des colonnes est donc améliorée.

D'autre part, le bruit de transfert colonne vers mémoire de ligne a deux origines, à savoir un bruit thermique qui est proportionnel à la racine carrée de la capacité colonne et un bruit proportionne, aux pièges de surface et de volume sous la grille de passage entre les colonnes et la mémoire de ligne. Le passage en transfert en volume réduit ces deux composantes en réduisant la capacité colonne comme mentionné ci-dessus et en supprimant les pièges de surface.

Toutefois, lors du transfert en volume, les effets de champ électrique latéral sont beaucoup plus importants que lors d'un transfert en surface. Il en résulte une modulation de la barrière de potentiel sous la grille de transfert prévue entre les colonnes conductrices et la mémoire de ligne, modulation qui a pour effet de limiter l'efficacité de transfert.

Conformément à la présente invention, pour remédier à cet inconvénient, la grille de passage entre les colonnes conductrices et la mémoire de ligne est constituée par une première grille portée à une tension continue fixant le potentiel de la colonne et une seconde grille portée à un potentiel périodique pour assurer le transfert des charges de la colonne vers la mémoire de ligne.

La présente invention a pour objet un dispositif photosensible à transfert de ligne comportant, sur au moins un substrat semiconducteur, une zone photosensible de M lignes de N points photosensibles, les points photosensibles des différentes lignes étant reliés en parallèle par des colonnes conductrices à un organe d'interface dit mémoire de ligne qui assure au moins le transfert des charges signal intégrées sur une même ligne de la zone photosensible vers un registre de lecture constitué par un registre à décalage à transfert de charge du type transfert en volume caractérisé en ce que la mémoire de ligne est réalisée sur au moins une zone de substrat semiconducteur présentant une implantation d'impuretés de type opposé à celui du substrat de manière à réaliser un transfert des charges "en volume", le dopage en impuretés de la zone de réalisation de la mémoire de ligne étant inférieur ou égal à celui de la zone de réalisation du registre à décalage et en ce que la mémoire de ligne comporte une série de capacités de stockage, chaque capacité étant relée à une colonne par l'intermédiaire d'une grille de passage constituée, dans le sens colonne vers capacités, par une première grille portée à une tension continue fixant le potentiel de la colonne et une seconde grille portée à un potentiel périodique pour assurer le transfert des charges de la colonne vers les capacités de stockage.

D'autres caractéristiques et avantages de la présente invention apparaîtront à la lecture de la description de divers modes de réalisation faite ci-après avec référence aux dessins ci-annexés dans lesquels :

- la figure 1 est une vue en plan schématique d'un premier mode de réalisation d'un dispositif photosensible à transfert de ligne non couvert par la présente invention ;

- les figures 2(a) et 2(b) sont respectivement une vue en coupe par A-A de la figure 1 et un schéma expliquant son fonctionnement ;

- les figures 3(a) et 3(b) sont respectivement une vue en coupe d'un mode de réalisation modifié de la présente invention et un schéma expliquant son fonctionnement ;

- les figures 4(a) et 4(b) sont respectivement une vue en coupe la semblable à celle de la figure 2(a) d'un autre mode de réalisation de la présente invention et un schéma expliquant son fonctionnement.

Dans les différentes figures, les mêmes références désignent les mêmes éléments mais pour des raisons de clarté les cotes et proportions des divers éléments ne sont pas respectées.

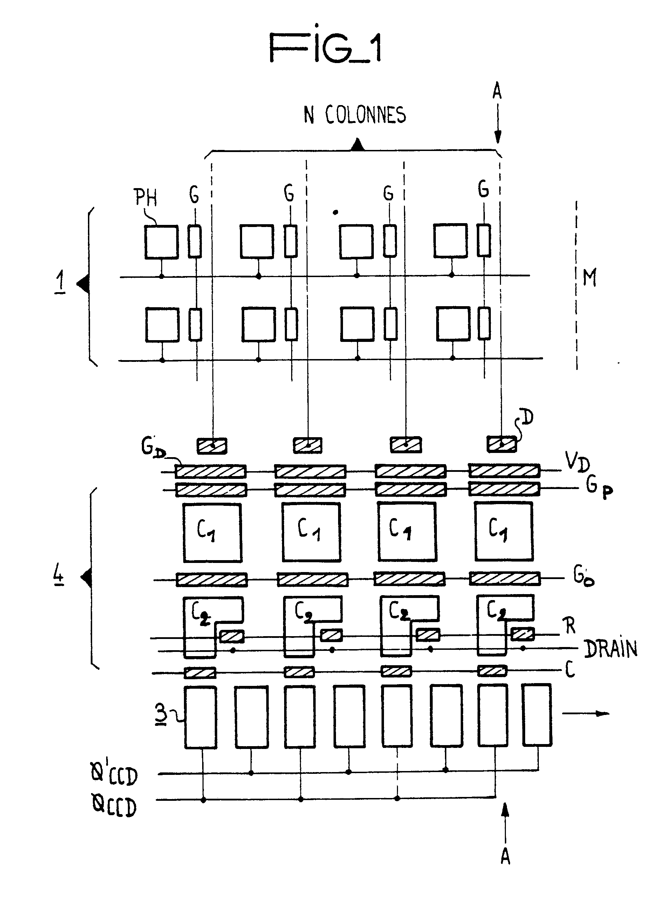

Les figures 1, 2(a) et 2(b) représentent différentes vues d'un dispositif photosensible à transfert de ligne.

Ce dispositif photosensible à transfert de ligne correspond au dispositif photosensible décrit dans la demande EP-A-0 115 225 au nom de la Demanderesse qui permet une analyse de l'image à l'aide d'une double charge d'entraînement.

Sur cette figure la référence 1 désigne la zone photosensible, la référence 4 la mémoire de ligne et la référence 3 le registre de lecture.

La zone photosensible 1 est constituée d'une matrice de M lignes comportant chacune N points photosensibles PH. Cette zone reçoit l'image lumineuse à analyser et la transforme en charges électriques dites charges-signal $Q_S$. Les points photosensibles d'une même ligne sont reliés entre eux et reliés à un registre d'adressage non représenté qui permet de sélectionner une ligne de la matrice. Les points photosensibles d'une même colonne sont reliés à une même connexion dite ci-après connexion de colonne vers une memoire de ligne 4. Comme représenté sur les figures 1 et 2(a), les connexions en provenance des colonnes de la matrice photosensible aboutissent chacune dans une diode D, dite diode de réception des charges-signal $Q_S$ en provenance de la matrice. Cette diode est réalisée, par exemple, par dopage en impuretés de type opposé à celui du substrat semiconducteur sur lequel est réalisée la matrice photosensible 1.

La mémoire de ligne 4 comporte, dans le mode de réalisation représenté, une série de capacités intermédiaires $C_1$ dans lesquelles se trouvent stockées les charges d'entraînement $Q_0$ comme expliqué dans les demandes EP-A-0 064 890 et EP-A-0 115 225 au nom de la Demanderesse. Une grille de passage $G_P$ contrôle le passage entre chaque colonne et la capacité intermédiaire correspondante. Le potentiel de cette grille a pour fonction de fixer le potentiel des connexions de colonne.

Comme dans les dispositifs photosensibles à transfert de ligne selon l'art antérieur, la grille de passage $G_P$ est précédée d'une grille écran $G_D$ qui a pour fonction de former un écran pour les charges entre les diodes D et le reste du dispositif représenté sur les figures 1 et 2(a), ce qui permet d'éviter l'envoi de charges parasites sur les connexions de colonne. En effet, dans les dispositifs à transfert de charge, il est particulièrement important de se protéger contre les charges parasites dont l'amplitude peut varier d'un point à l'autre du circuit selon les variations géométriques des éléments et qui limitent la dynamique du signal. A cet effet, la grille $G_D$ est reliée à un potentiel constant $V_D$.

Les capacités intermédiaires $C_1$ sont suivies par des moyens de commutation qui conduisent le contenu des capacités soit vers un drain d'évacuation, soit vers un registre le lecture 3.

Comme représenté sur la figure 1, les capacités intermediaires $C_1$ sont suivies de grilles $G_0$ permettant de retenir les charges d'entraînement $Q_0$ dans les capacités intermédiaires et fixant leurs amplitudes. Les grilles $G_0$ sont suivies de capacités $C_2$ qui servent de plaque tournante et permettent d'envoyer les charges venant des capacités $C_1$ soit vers le drain d'évacuation après passage d'une grille R soit vers le registre de lecture 3 après passage d'une grille C. L'accès à chaque capacité 2 est donc commandé par trois grilles. Une grille $G_0$ qui permet l'arrivée des charges et deux grilles R et C qui permettent leur départ soit vers le drain soit vers le registre de lecture.

Le registre de lecture 3 est constitué par un registre à transfert de charge du type CCD (Charge Coupled Device). Comme représenté sur la figure 2(a), le registre à transfert de charge 3 est un registre du type transfert en volume. D'autre part, on a représenté sur la figure 1, un registre à transfert de charge à deux phases de commande $\emptyset_{CCD}$ et $\overline{\emptyset}_{CCD}$, toutefois il est évident pour l'homme de l'art que la présente invention peut s'appliquer à des registres CCD du type transfert en volume comportant un nombre quelconque de phases de commande.

De ce fait, le registre de lecture 3 étant du type transfert en volume, il est interressant, conformément à la présente invention, de réaliser les différents éléments constituant la mémoire de ligne en utilisant le principe du transfert en volume. En conséquence, la mémoire de ligne 4 est réalisée sur une zone de substrat semiconducteur présentant une implantation d'impuretés de type opposé à celui du substrat, à savoir une implantation d'impuretés de type N pour un substrat de type P comme représenté sur la figure 2(a) où cette zone est référencée TV(N). Le dopage en impuretés de la zone mémoire de ligne 4 peut être inférieur ou égal à celui de la zone du registre à décalage 3 pour permettre au moins le transfert des charges de la mémoire de ligne 4 vers le registre CCD 3. Dans le mode de réalisation de la figure 2(a), on a représenté des dopages en impuretés égaux pour les deux zones. Dans ce cas, comme représenté par les flèches F et F' sur la figure 2(b), il est possible de transférer des charges aussi bien de la mémoire de ligne vers le registre CCD que du registre CCD vers la mémoire de ligne, ce qui est particulièrement avantageux dans le cas d'un fonctionne ment avec double charge d'entraîne ment tel que décrit dans la demande EP-A-0 115 225.

Lorsque le dopage en impuretés de la zone mémoire est inférieur à celui du registre CCD, un transfert bilatéral des charges entre la mémoire et le registre de lecture n'est plus possible. Toutefois, un dispositif photosensible à transfert de ligne comportant une mémoire de ligne réalisée avec transfert en volume présente un certain nombre d'avantages spécifiques tels qu'une amélioration de l'efficacité de transfert vertical colonnes vers mémoire de ligne et une diminution des bruits de transfert, comme décrit dans l'introduction de la présente demande.

Cependant, comme représenté sur la figure 2(b), cette efficacité de transfert vertical est limitée par un phénomène connu dû à l'interaction entre la grille de passage $G_P$ et la capacité intermédiaire $C_1$. Au niveau de la jonction entre ces deux éléments, il y a création d'un champ électrique latéral qui est d'autant plus important que le transfert en volume est plus profond.

Comme représenté sur la figure 2(b), avant la réalisation du transfert de la charge ($Q_S + Q_0$ dans le cas d'un fonctionnement avec double charge d'entraînement) de la colonne vers la capacité intermédiaire $C_1$, le potentiel sous la grille de passage $G_P$ est au niveau bas, à savoir selon le tracé en tireté référencé (1). Pour réaliser le transfert de la charge, la barrière de potentiel

sous la grille $G_P$ passe au niveau haut, à savoir dans la position en trait plein référencé (2). La charge ($Q_S + Q_0$) est alors transférée sous la capacité $C_1$ qui se trouve au niveau haut et le potentiel sous $C_1$ evolue de manière à se trouver dans la configuration référencée (3). L'évolution du potentiel de (2) vers (3) sous la capacité $C_1$ induit sous la grille de passage $G_P$ une évolution de potentiel $\emptyset_S$ vers $\overline{\emptyset}_S$ représentée en tireté. Cette variation induite $\Delta\emptyset = \emptyset_S - \overline{\emptyset}_S$ est d'autant plus importante que le transfert en volume est plus profond; car dans ce cas les champs latéraux sont plus intenses. Comme représenté clairement sur la figure 2(b), la variation $\Delta\emptyset$ module le courant colonne vers la capacité $C_1$ aussi bien en régime de forte inversion que de faible inversion, ce qui se traduit par une rétention d'une partie des charges sur la colonne et en conséquence par une inéfficacité de transfert vertical.

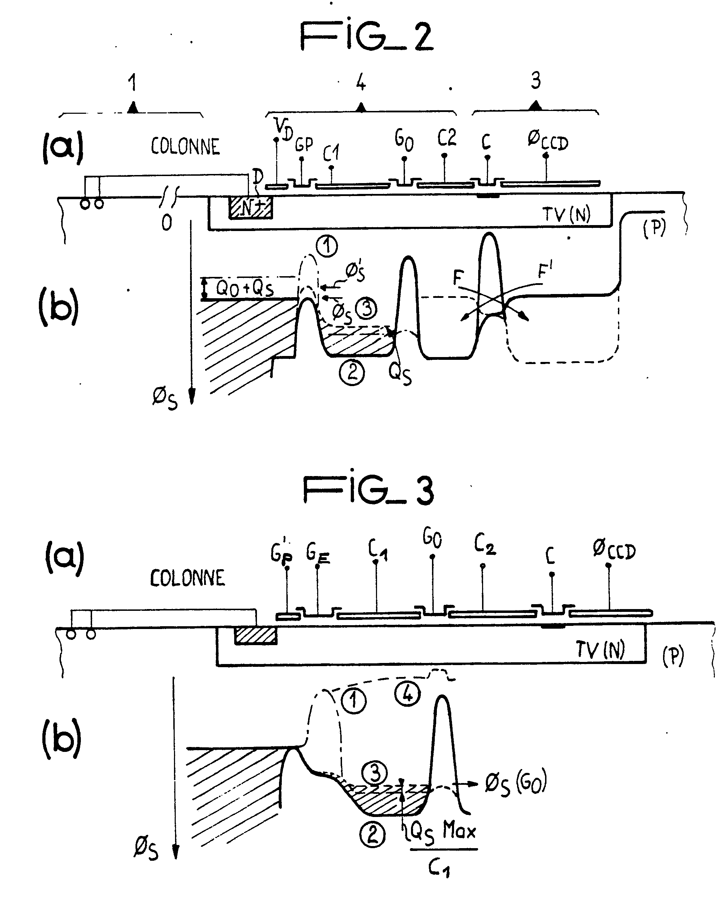

Conformément à la présente invention et comme représenté aux figures 3(a) et 3(b), on a proposé de résoudre ce problème en utilisant une grille de passage constituée par une première grille de passage $G_P$ située tout de suite après la diode D et portée à une tension de polarisation continue qui règle exactement le potentiel de la colonne et par une deuxième grille $G_E$ située entre la grille de passage et la capacité $C_1$ et dont la fonction est de provoquer ou interrompre le transfert selon que cette grille est polarisée à un niveau haut ou à un niveau bas.

Avec cette structure particulière, le potentiel de surface sous les grilles $G'_P$ et $G_E$ et la capacité de stockage intermédiaire $C_1$ présente la configuration référencée (1) sur la figure 3(b). Lors du transfert des charges, la grille $G_E$ est portée à un niveau haut tel que son potentiel de surface $\emptyset_S$ ($G_{Ehaut}$) soit compris entre les potentiels de surface $\emptyset_S$ ($G'_P$) et $\emptyset_S$ ($C_{1haut}$). De préférence dans le cas d'un dispositif photosensible à transfert de ligne du type fonctionnant avec une double charge d'entraînement comme représenté à la figure 3(a), le potentiel de surface ($G_{Ehaut}$) répond à l'équation suivante :

$$\emptyset_S(G'_P) < \emptyset_S(G_{Ehaut}) < \emptyset_S(G_{Ohaut}) + \frac{Q_{Smax}}{C_1}$$

de sorte qu'aucune charge ne puisse être stockée sous la grille $G_E$. Dans ces conditions, la grille $G_E$ isole le potentiel sous la grille de passage $G'_P$ des fluctuations de potentiel sous la capacité $C_1$ qui sont fonction de la charge signal. En conséquence l'efficacité de transfert se trouve considérablement améliorée.

D'autre part, notamment dans le cas d'un fonctionnement avec double charge d'entraînement tel que réalisé avec le dispositif photosensible de la figure 3(a), le niveau bas appliqué sur la grille $G_E$ doit être tel que :

$$\emptyset_S(G_{Ebas}) \geqslant \emptyset_S(G_{1bas}) > \emptyset_S(G_{Obas})$$

pour que la charge $Q_0$ puisse être restituée

intégralement sur la colonne. De plus, pour réaliser cette condition et éviter par ailleurs que la charge $Q_0$ ne puisse s'écouler en partie vers la capacité $C_2$ lorsque la capacité $C_1$ est au niveau bas, il est utile de réaliser une implantation d'isolement sous la grille $G_0$ prévue entre la capacité $C_1$ et la capacité $C_2$. On obtient alors le profil de potentiel référencé (4) sur la figure 3(b).

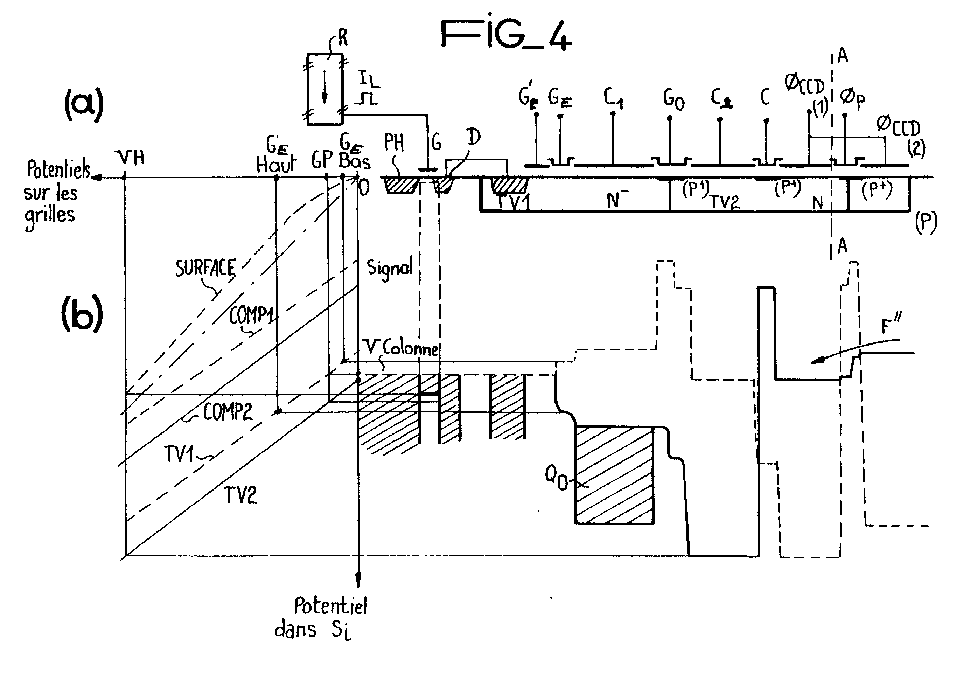

Sur les figures 4(a) et 4(b), on a représenté un autre mode de réalisation de la présente invention. Conformément à ce mode de réalisation les éléments de la mémoire de ligne sont réalisés sur deux zones de transfert en volume présentant des concentrations en impuretés différentes ;

- une zone de faible concentration $TV_1$ (N⁻) qui s'étend sous la grille de passage $G_E$, la capacité $C_1$ et la moitié de la grille intermédiaire $G_0$.

- une zone de concentration plus élevée $TV_2$ (N) qui s'étend depuis le milieu de la grille intermédiaire $G_0$ jusqu'au registre de lecture à transfert de charge ou jusqu'au milieu de la grille de passage $\emptyset_P$ dans le cas où le dispositif photosensible à transfert de ligne comporte deux registres à décalage à transfert de charge $\emptyset_{CCD\,1}$ et $\emptyset_{CCD\,2}$ utilisé pour l'injection de la deuxième charge d'entraîne ment comme décrit dans la demande de premier certificat d'addition à la demande de brevet français FR-A-2 538 200.

Selon un mode de réalisation préférentiel, la zone de concentration plus élevée $TV_2$ (N) est réalisée par enrichissement de la zone $TV_1$ qui s'étend initiale ment sous toute la mémoire de ligne ainsi que sur le ou les registres CCD selon le type de dispositif photosensible utilisé.

D'autre part, une même diffusion d'impuretés (P+) fixe les potentiels dans les zones de transfert du registre CCD de lecture sous la grille C et sous la grille $G_0$. Les potentiels de surface sous les différentes grilles sont donnés par les caractéristiques COMP 1, $TV_1$ ou COMP 2, $TV_2$ représentées sur la partie gauche de la figure 4(b) selon que l'on se trouve dans la zone $TV_1$ ou $TV_2$. La partie gauche de la figure 4(b) est un graphique représentant diverses courbes fonction du dopage du substrat et donnant le potentiel de surface en fonction du potentiel appliqué sur les grilles.

La configuration de la figure 4(a) est particulièrement intéressante lorsque l'élément photosensible est une photodiode. En effet, il est indispensable pour éviter un effet de rémanence que l'impulsion IL provenant du registre à décalage vertical R et appliquée sur la grille de lecture G soit suffisamment importante pour qu'au moment de la lecture le transistor MOS constitué par l'ensemble photodiode PH, grille de lecture G et diode D soit polarisé en triode. Dans ce cas la colonne impose son potentiel sur la photodiode comme représenté sur la figure 4(b) et il n'y a pas d'autres rémanences que l'inefficacité de transfert vertical.

En effet, si l'amplitude de l'impulsion IL n'est pas suffisante le transistor MOS ci-dessus est polarisé en saturation et le transfert des charges-signal sur la colonne se termine en faible inversion, ce qui se traduit par un effet de rémanence d'autant plus important que l'on se trouve à un niveau de lumière plus faible.

Or, dans le cas où la mémoire de ligne est réalisée avec un transfert en volume, le potentiel appliqué sur la colonne est élevé ce qui est un avantage au point de vue de la capacité colonne mais un inconvénient au niveau de la commande de lecture des photodiodes. Dans ce cas, en effet, le niveau haut de l'impulsion IL doit être supérieur au potentiel colonne plus le seuil de la grille de lecture pour que le transistor NOS constitué par la photodiode PH, la grille de lecture G et la diode D soit en régime triode. De plus, pour réaliser un bon isolement avec une dynamique de stockage importante entre les photodiodes PH et les colonnes conductrices correspondantes, le seuil de la grille de lecture G doit être positif, c'est à dire que le transfert sous cette grille s'effectue en surface. L'ensemble de ces conditions impliquent un niveau haut pour IL très important lorsque le dopage en impuretés de la zone-mémoire de ligne est élevé ce qui est nécessaire pour obtenir une bonne efficacité de transfert dans le registre de lecture J.

La structure représentée à la figure 4(a) dans laquelle la zone-mémoire de ligne 4 est réalisée sur deux zones $TV_1$ et $TV_2$ de concentrations différentes permet de limiter l'amplitude de l'impulsion IL sans modifier l'efficacité de transfet du registre CCD.

Dans ce cas, comme représenté clairement sur la figure 4(b), l'impulsion IL peut avoir la même amplitude $V_H$ que les phases de commande $\emptyset_{CCD}$ appliquées sur le registre de lecture. Lorsque l'impulsion IL est au niveau haut, on se trouve bien en régime triode car

$$V_{colonne} = \emptyset_{TV1} (G_P) < \emptyset_{surface} (V_H)$$

alors que cette relation ne peut pas être obtenue avec $V_{colonne} \emptyset_{TV2} (G_P)$.

D'autre part, dans le cas d'un dispositif photosensible fonctionnant avec double charge d'entraînement, il est interessant que le niveau bas de $G_E$ soit égal à $G_P/2$ de manière à satisfaire la relation

$$|V_{col}| > \emptyset_{TV1}(G_{Ebas})| > |\emptyset_{TV1}(0)|$$

Ainsi la charge d'entraînement peut être transférée des capacités $C_1$ sur les colonnes conductrices, comme représenté sur la figure 4(b).

Par ailleurs, la zone $TV_2$ de forte concentration d'impuretés commence au milieu de la grille $G_0$ séparant les capacités intermédiaires $C_1$ des capacités $C_2$. Il en résulte un effet d'écran qui améliore le transfert des capacités $C_1$ vers les capacités $C_2$ En effet :

- la partie $TV_2$ de la grille $G_0$ fixe le potentiel sous la capacité $C_1$ en retenant la charge $Q_0$ ;

- et la partie $TV_2$ de la grille $G_0$ isole la partie $TV_1$ de l'influence des variations de potentiel

sous la capacité $C_2$ en fonction du signal transféré, comme expliqué ci-dessus avec référence aux figures 3(a) et 3(b).

De plus, dans le cas où l'on utilise deux registres CCD $\emptyset_{CCD1}$ et $\emptyset_{CCD2}$, l'un pour la lecture et l'autre pour l'injection de charges, comme mentionné ci-dessus, le second registre $\emptyset_{CCD2}$ est réalisé de préférence dans la zone $TV_1$ comme représenté sur la figure 4(a). Le transfert de la charge symbolisé par F" se fait alors de la zone $TV_1$ vers $TV_2$ lorsque la phase des registres $\emptyset_{CCD1}$ et $\emptyset_{CCD2}$ est au niveau bas, la grille $\emptyset_P$ étant polarisée à un niveau intermédiaire.

Dans la description ci-dessus, on a fait référence à des dispositifs photosensibles à transfert de ligne du type de ceux décrits dans les demandes EP-A-0 064 890 et EP-A-0 225 225. Cependant il est évident pour l'homme de l'art que la présente invention peut aussi s'appliquer à d'autres types de dispositifs photosensibles comportant un organe d'interface entre la zone photosensible et un registre à décalage à transfert de charge.

## Revendications

1. Dispositif photosensible à transfert de ligne comportant, sur au moins un substrat semiconducteur, une zone photosensible (1) de M lignes de N points photosensibles, les points photosensibles (PH) des différentes lignes étant reliés en parallèle par des colonnes conductrices à un organe d'interface dit mémoire de ligne (4) qui assure au moins le transfert des charges signal intégrées sur une même ligne de la zone photosensible vers un registre de lecture (3) constitué par un registre à décalage à transfert de charge du type transfert en volume caractérisé en ce que la mémoire de ligne (4) est réalisée sur au moins une zone (TV) de substrat semiconducteur présentant une implantation d'impuretés de type opposé à celui du substrat de manière à réaliser un transfert des charges "en volume'", le dopage en impuretés de la zone de réalisation de la mémoire de ligne étant inférieur ou égal à celui de la zone de réalisation du registre à décalage et en ce que la mémoire de ligne comporte une série de capacités de stockage ($C_1$), chaque capacité étant reliée à une colonne par l'intermédiaire d'une grille de passage ($G_P$) constituée, dans le sens colonne vers capacités, par une première grille ($G'_P$) portée à une tension continue fixant le potentiel de la colonne et une seconde grille ($G_E$) portée à un potentiel périodique pour assurer le transfert des charges de la colonne vers les capacités de stockage.

2. Dispositif selon la revendication 1 caractérisé en ce que chaque capacité de stockage ($C_1$), reliée d'une part à une colonne par l'intermédiaire de la grille de passage ($G_P$) fixant le potentiel de ladite colonne, est reliée autre part à des moyens de commutation (C) assurant au moins le transfert des charges de la capacité ($C_1$) vers le registre de lecture (3).

3. Dispositif selon la revendication 1 caractérisé en ce que la mémoire de ligne est constituée par deux séries de capacités de stockage ($C_1$, $C_2$) positionnées en parallèle sur le trajet des charges et séparées l'une de l'autre par une grille intermédiaire ($G_O$) portée à un potentiel assurant le stockage d'une quantité prédéterminée de charge, chaque capacité ($C_1$) de la première série étant reliée à une colonne par l'intermédiaire d'une grille de passage ($G_P$) fixant le potentiel de ladite colonne et chaque capacité ($C_2$) de la deuxième série étant reliée à des moyens de commutation (C) assurant au moins le transfert des charges des capacités ($C_2$) vers le registre de lecture (3).

4. Dispositif selon la revendication 3 caractérisé en ce que le niveau haut du potentiel de surface sous la seconde grille ($C_E$) répond à l'équation

$$\emptyset(G'_P) < \emptyset_S(G_{Ehaut}) < \emptyset_S(G_{Ohaut}) + \tfrac{Q_{Smax}}{C_1}$$

avec $\emptyset_S(G'_P)$ : le potentiel de surface sous la première grille ($G'_P$) $\emptyset_S(G_{Ohaut})$ : le niveau haut du potentiel de surface de la grille intermédiaire ($G_O$);
$C_1$ : la valeur de la première série de capacités ($C_1$);
$Q_{Smax}$ : la quantité de charge signal maximale.

5. Dispositif selon l'une des revendications 3 ou 4 caractérisé en ce que le niveau bas du potentiel de surface sous la seconde grille répond à l'équation

$$\emptyset_S(G_{Ebas}) \geqslant \emptyset_S(C_{1bas}) > \emptyset_S(G_{Obas})$$

avec $\emptyset_S(C_{1bas})$: le niveau bas du potentiel de surface sous la première série de capacités ($C_1$),
$\emptyset_S(G_{Obas})$ : le niveau bas du potentiel de surface sous la grille intermédiaire ($G_O$).

6. Dispositif selon la revendication 5, caractérisé en ce qu'une implantation d'impuretés de même type que celui du substrat est réalisée sous la grille intermédiaire ($G_O$).

7. Dispositif selon la revendication 3, caractérisé, en ce que la zone ($TV_1$) du substrat semiconducteur se trouvant sous la ou les grilles de passage ($G_E$, $G'_P$), sous la première série de capacités de stockage ($C_1$) et sous la première moitié de la grille intermédiaire ($G_O$) présente une concentration en impuretés inférieur à celle de la zone ($TV_{12}$) se trouvant sous la deuxième moitié de la grille intermédiaire ($G_O$), la deuxième série de capacités ($C_2$), les moyens de commutations (C) et le registre de lecture (3).

## Patentansprüche

1. Photoempfindliche vorrichtung, die mit Zeilenüberführung arbeitet, und auf wenigstens einem Halbleitersubstrat mit einer photoempfindlichen Zone (1) aus M Zeilen mit N photoempfindlichen Punkten versehen ist, wobei die photoempfindlichen Punkte (PH) der verschiedenen Zeilen parallel durch leitende Spalten mit einem als Zeilenspeicher (4) bezeichneten schnittstellelement verbunden ist, welches wenigstens die Überführung der über eine selbe Zeile der photoempfindlichen Zone integrierten Signalladungen zu einem Leseregister (3) gewährleistet, welches aus einem Schieberegister, das mit Ladungsüberführung arbeitet, vom Typ mit volumenweise Oberführung besteht, dadurch gekennzeichnet, daß der Zeilenspeicher (4) auf wenigstens einer Zone (TV) eines Halbleitersubstrats ausgebildet ist, welches eine Verunreinigungsimplantation vom entgegengesetzten Typ des Substrats aufweist, so daß eine "volumenweise" Ladungsüberführung gebildet wird, wobei die Verunreinigungsdotierung der Zone, wo der Zeilenspeicher ausgebildet ist, kleiner als die oder gleich der Dotierung der Zone ist, wo das Schieberegister ausgebildet ist, und daß der Zeilenspeicher eine Reihe von Speicherkapazitäten ($C_1$) aufweist, wobei jede Kapazität mit einer Spalte durch eine Überleitungselektrode ($G_P$) verbunden ist, welche, in Richtung Spalte zu Kapazitäten, aus einer ersten auf eine das Potential der Spalte festlegende Gleichspannung gelegten Elektrode ($G'_P$), und aus einer zweiten Elektrode ($G_E$) besteht, die auf ein periodisches Potential gelegt wird, um die Ladungsüberführung von der Spalte zu den Speicherkapazitäten zu gewährleisten.

2. Vorrichtung nach Anspruch 1, dadurch gekennzeichnet, daß jede Speicherkapazität ($C_1$), die einerseits mit einer Spalte durch die Überleitungselektrode ($G_P$), welche das Potential derselben Spalte festlegt, verbunden ist, andererseits mit umschaltmitteln (C), die wenigstens die Ladungsüberführung der Kapazität ($C_1$) zum Leseregister (3) gewährleistet, verbunden ist.

3. Vorrichtung nach Anspruch 1, dadurch gekennzeichnet, daß der Zeilenspeicher aus zwei Reihen von Speicherkapazitäten ($C_1$, $C_2$) besteht, die parallel auf dem Weg der Ladungen angeordnet sind und die durch eine zwischenelektrode ($G_O$) voneinander getrennt sind, welche auf ein die Speicherung einer vorbestimmten Ladungsmenge gewährleistendes Potential gelegt ist, wobei jede Kapazität ($C_1$) der ersten Reihe mit einer Spalte durch eine Überleitungselektrode ($G_P$) verbunden ist, die das potential derselben Spalte festlegt, und wobei jede Kapazität ($C_2$) der zweiten Reihe mit umschaltmitteln (C) verbunden ist, welche wenigstens die Überführung der Ladungen der Kapazitäten ($C_2$) zum Leseregister (3) gewährleisten.

4. Vorrichtung nach Anspruch 3, dadurch gekennzeichnet, daß der hohe Pegel des Oberflächenpotentials unter der zweiten Überleitungselektrode ($G_E$) der Gleichung

$$\emptyset_S (G'_P) < \emptyset_S (G_{Ehoch}) < \emptyset_S (G_{Ohoch}) + \frac{Q_{Smax}}{C_1}$$

entspricht, worin

$\emptyset_S (G'_P)$ das Oberflächenpotential unter der ersten Überleitungselektrode ($G'_P$) ist ;

$Q_S(G_{Ohoch})$ der hohe Pegel des Oberflächenpotentials der Zwischenelektrode ($G_O$) ist ;

$C_1$ der Wert der ersten Reihe der Kapazitäten ($C_1$) ist ;

$Q_{Smax}$ die Menge der maximalen Signalladung ist.

5. Vorrichtung nach dem Anspruch 3 oder 4, dadurch gekennzeichnet, daß der niedrige Pegel des Oberflächenpotentials unter der zweiten Elektrode der Gleichung

$$\emptyset_S(G_{Eniedrig}) \geqslant \emptyset_S (C_{1\ niedrig}) > \emptyset_S (G_{O\ niedrig})$$

entspricht, worin

$\emptyset_S (C_{1\ niedrig})$ der niedrige Pegel des Oberflächenpotentials unter der ersten Reihe der Kapazitäten ($C_1$) ist und

$\emptyset_S(G_{O\ niedrig})$ der niedrige Pegel des Oberflächenpotentials unter der Zwischenelektrode ($G_O$) ist.

6. Vorrichtung nach Anspruch 5, dadurch gekennzeichnet, daß eine Verunreinigungsimplantation desselben Typs wie der des Substrats unter der Zwischenelektrode ($G_O$) gebildet ist.

7. Vorrichtung nach Anspruch 3, dadurch gekennzeichnet, daß die Zone ($TV_1$) des Halbleitersubstrats, die sich unter der oder den Überleitungselektroden ($G_E$, $G'_P$) befindet, unter der ersten Reihe der Speicherkapazitäten ($C_1$) und unter der ersten Hälfte der Zwischenelektrode ($G_O$) befindet, eine Verunreinigungskonzentration aufweist, die kleiner ist als die der Zone ($TV_2$), welche sich unter der zweiten Hälfte der Zwischenelektrode ($G_O$), der zweiten Kapazitätsreihe ($C_2$), um Umschaltsmitteln (C) und dem Leseregister (3) befindet.

**Claims**

1. A line transfer photosensitive device comprising, on at least one semiconductor substrate, a photosensitive zone (1) of M lines of N photosensitive dots, the photosensitive dots (PH) of the different lines being connected in parallel by conducting columns with an interface device termed the line memory (4) which assures at least the transfer of the integrated signal charges on a single line of the photosensitive zone to a read register (3) constituted by a charge transfer shift register of the volume transfer type characterized in that the line memory (4) is produced on at least one zone (TV) of the semiconductor substrate having an impurity implantation of the type opposite to that of the substrate in order to effect a "volumetric" charge transfer, the doping with impurities of the zone where the line memory is effected being less than or equal to that of the zone of production of the shift register and in that the line memory comprises a series of hold capacitors ($C_1$), each capacitor being connected with a column by the intermediary of a passage grid ($G_P$) constituted, in the column direction towards the capacitors, by a first grid ($G'_P$) placed at a direct voltage determining the potential of the column and a second grid ($G_P$) placed at a periodic potential in order to ensure the transfer of the charges from the column towards the hold capacitors.

2. The device as claimed in claim 1 characterized in that each hold capacitor (4) connected on the one-hand with a column by the intermediary of the passage grid ($G_P$) determining the potential of the said column, is connected on the other hand with switching means (C) assuring at least the transfer of the capacitor ($C_1$) to the read register (3).

3. The device as claimed in claim 1 characterized in that the line memory is constitued by two series of hold capacitors ($C_1$ and $C_2$) placed in parallel on the path of the charges and separated from each other by an intermediate grid ($G_O$) placed at a potential assuring the holding of a predetermined amount of charge, each capacitor ($C_1$) of the first series being connected with a column through the intermediary of a passage grid ($G_P$) determining the potential of the said column and each capacitor ($C_2$) of the second series being connected with switching means (C) assuring at least the transfer of the charges of the capacitors ($C_2$) to the read register,

4. The device as claimed in claim 3 characterized in that the high surface potential level under the second grid ($G_E$) complies with the equation:

$$\emptyset_S(G'_P) < \emptyset_S(G_{highE}) < (G_{highO}) + \tfrac{Q_{Smax}}{C_1}$$

wherein $\emptyset_S(G'_P)$ denotes the surface potential under the first grid ($G'_P$);

$Q_S(G_{highO})$ denotes the high surface potential level of the intermediate grid ($G_O$);

$C_1$ denotes the value of the first series of capacitors ($C_1$);

$Q_{Smax}$ denotes the maximum quantity of charge signal.

5. The device as claimed in claim 3 or claim 4 characterized in that the low level of the surface potential under the second grid complies with the equation:

$$\emptyset_S(G_{lowE}) > \emptyset_S(C_{low1}) > \emptyset_S(G_{lowO}),$$

wherein $\emptyset_S(C_{low1})$ denotes the surface potential level under the first series of capacitors ($C_1$), and $\emptyset_S(G_{lowO})$ denotes the low level of the surface potential under the intermediate grid ($G_O$).

6. The device as claimed in claim 5 characterized by an implantation of impurities of the same type as that of the substrate under the intermediate grid ($G_O$).

7. The device as claimed in claim 3 characterized in that the semiconductor substrate zone ($TV_1$) located under the passage grid or grids ($G_E$ and $G'_P$) and under the first series of hold capacitors ($C_1$) and under the first half of the intermediate grid ($G_O$) has a concentration of impurities less than that of the zone ($TV_2$) located under the second half of the intermediate grid ($G_O$), the second series of capacitors ($C_2$), the switching means (C) and the read register (3).

FIG_1

# FIG_2

(a)

1      4      3

COLONNE

$V_D$   GP   C1    $G_0$   C2   C   $\emptyset_{CCD}$

D

$N+$      TV (N)    (P)

0

(b)

①   $\emptyset'_S$

$Q_0 + Q_S$   $\emptyset_S$ ③

②   $Q_S$   F   F'

$\emptyset_S$

# FIG_3

(a)

COLONNE

$G'_P$   $G_E$   $C_1$   $G_0$   $C_2$   C   $\emptyset_{CCD}$

TV (N)   (P)

(b)

①   ④

③   $\emptyset_S (G_0)$

②   $Q_S$ Max

$\dfrac{}{C_1}$

$\emptyset_S$

FiG_4

(a)

(b)

0 141 695